# DEMANDE DE BREVET EUROPEEN

(11) **EP 0 562 981 A1**
(43) Date de publication de la demande: **29.09.1993**
(21) Numéro de dépôt: 93420127.8
(22) Date de dépôt: 23.03.1993
(51) Int. Cl.: H01L 33/00, H01L 21/306

(54) **Dispositif luminescent à couche mince de silicium**

(30) Priorité: 25.03.1992 FR 9203969
(71) Demandeur: CENTRE NATIONAL DE LA RECHERCHE SCIENTIFIQUE (CNRS), 75700 Paris Cedex 07 (FR)
(72) Inventeur: Bustarret, Etienne, F-38170 Seyssinet (FR); Ligeon, Mireille, F-38330 Biviers (FR); Muller, Fritz, F-38330 Saint Ismier (FR); Bruyere, Jean-Claude, F-38610 Venon (FR)
(74) Mandataire: de Beaumont, Michel

(57) **Abrégé**

La présente invention concerne un dispositif luminescent comprenant, sur un substrat conducteur (1), une couche de silicium amorphe (2) dopée pour être conductrice dont au moins une partie supérieure (3) a été rendue poreuse par anodisation et oxydée. Le substrat peut être un métal, une plaquette de silicium monocristallin dopée et métallisée sur sa face arrière, un polymère conducteur, une plaquette de verre revêtue d'une couche conductrice transparente du côté du dépôt de silicium amorphe...

## Description

La présente invention concerne le domaine des dispositifs luminescents (électroluminescents et photoluminescents) et plus particulièrement de tels dispositifs réalisés à base de silicium.

Les phénomènes de luminescence du silicium poreux ont été observés depuis 1990. Une synthèse et une tentative d'explication de ces phénomènes apparaissent dans l'article de Louis Brus, Nature, Vol. 353, 26 Septembre 1991, pp. 301-302. Cet article rappelle que la luminescence du silicium a été observée dans des tranches de silicium massif anodisé pour le rendre poreux et attribue cette luminescence à l'existence de cristallites de silicium. Ainsi, la luminescence serait liée à la présence d'éléments cristallins de petite dimension dans du silicium poreux formé à partir de silicium monocristallin massif.

La présente invention vise à l'obtention de dispositifs luminescents dans du silicium en couche mince.

La présente invention s'écarte des enseignements de l'art antérieur en ce qu'elle propose une structure présentant des propriétés de luminescence obtenue à partir de silicium amorphe rendu poreux, c'est-à-dire que, contrairement à la théorie dominante exposée dans l'article susmentionné, cette luminescence ne serait pas uniquement déterminée par la nature cristalline du silicium et l'existence de cristallites de petites dimensions dans du silicium monocristallin rendu poreux.

Ainsi, la présente invention propose un dispositif luminescent comprenant, sur un substrat conducteur, une couche de silicium amorphe déposée dont au moins une partie supérieure a été rendue poreuse par anodisation.

Selon un mode de réalisation de la présente invention, l'épaisseur de la couche de silicium amorphe est de l'ordre de 0, 2 à 2 micromètres.

Selon un mode de réalisation de la présente invention, l'épaisseur de la couche anodisée rendue poreuse est de l'ordre de 10 nm à 1 µm.

Selon un mode de réalisation de la présente invention, le substrat est un métal.

Selon un mode de réalisation de la présente invention, le substrat est une plaquette de silicium monocristallin dopée et métallisée sur sa face arrière.

Selon un mode de réalisation de la présente invention, le substrat est un polymère conducteur.

Selon un mode de réalisation de la présente invention, le substrat est une plaquette de verre revêtue d'une couche conductrice transparente du côté du dépôt de silicium amorphe.

Selon un mode de réalisation de la présente invention, la couche anodisée rendue poreuse est oxydée

Selon un mode de réalisation de la présente invention, la couche de silicium poreux est revêtue d'un diélectrique transparent de protection tel que du nitrure de silicium.

Selon un mode de réalisation de la présente invention, le dépôt de silicium amorphe est effectué à une température inférieure à 400°C.

Les caractéristiques et les avantages de la présente invention seront exposés plus en détail dans la description suivante de modes de réalisation particuliers faite en relation avec les figures jointes parmi lesquelles :
les figures 1, 2 et 3 représentent trois étapes successives de fabrication d'un dispositif selon la présente invention ; et
les figures 4 et 5 illustrent des résultats obtenus avec un dispositif selon la présente invention.

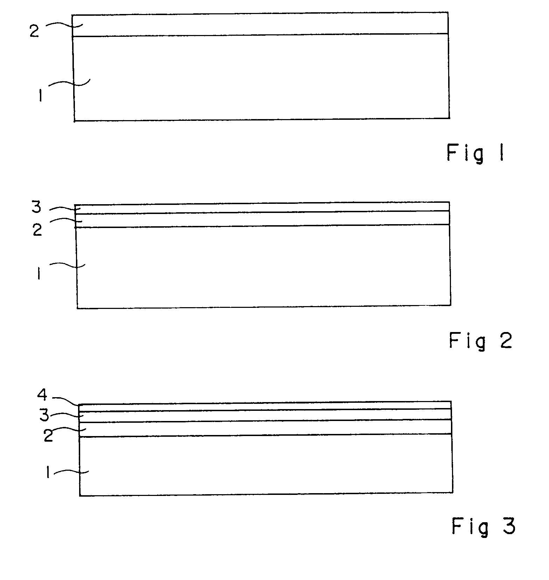

Comme le représente la figure 1, la présente invention propose d'utiliser un substrat conducteur, ou revêtu d'une couche conductrice, sur lequel est déposée une couche de silicium amorphe 2 ayant par exemple une épaisseur de l'ordre de 2 µm.

Selon un mode de réalisation de la présente invention, cette couche de silicium amorphe est fortement dopée au bore, au point de constituer un alliage bore-silicium contenant environ 1 % d'atomes de bore, cet alliage ayant une résistivité de l'ordre de quelques ohms. cm. Cette Couche est par exemple déposée en utilisant le procédé décrit dans l'article de Y. Audet et al, publié dans IPAT91 International Conference Proceedings (édité par CEP Ltd, Edinburgh UK), Bruxelles, 21-24 Mai 1991, page 190 et suivantes.

Comme l'enseigne cet article, ce dépôt peut être effectué à relativement faible température, par exemple à des températures comprises entre la température ambiante et 400°C. Comme on le verra ci-après, ceci présente l'avantage que l'on peut utiliser de multiples variétés de substrats qui ne résisteraient pas aux températures de dépôt ou de recuit de silicium polycristallin ou monocristallin.

Ensuite, dans une étape ultérieure illustrée en figure 2, la couche de silicium amorphe 2 est traitée par anodisation en présence d'acide fluorhydrique dilué (par exemple à 15 %) de sorte que sa partie supérieure 3 est rendue poreuse. Ceci est possible parce que, comme on l'a indiqué précédemment, le silicium amorphe est fortement dopé et relativement conducteur. Une variante de réalisation consisterait à utiliser du silicium amorphe non dopé et à le rendre conducteur pendant la phase d'anodisation par éclairement à des longueurs d'onde de 0,5 à 0,8 µm.

Cette anodisation est poursuivie jusqu'à transformer une épaisseur de la couche de silicium amorphe inférieure à son épaisseur totale, par exemple une épaisseur de 10 nm à 1 µm. Cette étape d'anodisation est de préférence suivie d'une étape d'oxydation, par exemple par voie électrochimique ce qui garantit une meilleure stabilité structurale et chimique du matériau poreux. Ensuite, pour isoler la couche active de l'atmosphère ou pour moduler sa réponse optique, on dépose, comme cela est représenté en figure 3, un diélectrique 4, de préférence transparent, protégeant le silicium amorphe poreux oxydé sous-jacent d'une oxydation ultérieure. Ce diélectrique anti-oxydation pourra par exemple être un dépôt de nitrure de silicium.

On a ainsi obtenu un dispositif dans lequel la couche de silicium amorphe poreux est photoluminescente, c'est-à-dire qu'elle réémet de la lumière à la suite d'une excitation optique. On peut également obtenir un dispositif électroluminescent en appliquant une tension électrique à la couche 3 revêtue d'une couche conductrice, par exemple une couche métallique, avant un dépôt éventuel de nitrure de silicium.

A titre d'exemple de substrat, on peut utiliser selon la présente invention un substrat métallique, par exemple de l'acier, un substrat constitué de silicium monocristallin dopé, métallisé sur sa face arrière, un substrat constitué d'un polymère conducteur, ou encore un substrat constitué d'une plaque de verre revêtue d'une couche conductrice transparente. On notera en particulier que l'utilisation de ces deux derniers types de substrat est seulement possible en raison de la faible température de dépôt du silicium amorphe.

Les figurés 4 et 5 illustrent des résultats obtenus avec des dispositifs selon la présente invention dans le cas où le substrat était en acier inoxydable.

La figuré 4 représente le spectre de photoluminescence PL en unités arbitraires en fonction de la longueur d'onde λ (en nanomètres) après anodisation dans de l'acide fluorhydrique dilué et oxydation anodique. On voit que la photoluminescence a un spectre relativement large dont le maximum est situé aux environs de 700 nm, c'est-à-dire à la limite du rouge et de l'infrarouge.

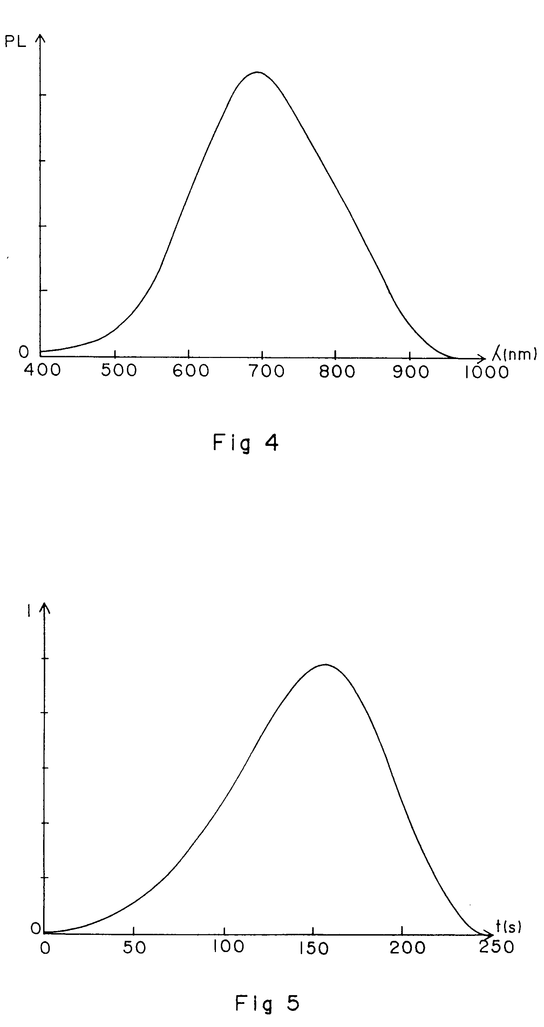

La figure 5 illustre pour un même échantillon la réponse en intensité lumineuse intégrée sur toute la plage de longueur d'onde en fonction du temps (en secondes) pour la lumière émise pendant l'oxydation anodique en milieu non fluorhydrique du silicium amorphe préalablement rendu poreux. Ce phénomène d'électroluminescence en présence d'une phase liquide lors de l'oxydation anodique d'une couche de silicium poreux est décrit dans le cas de silicium monocristallin par A. Halimanoui et al, Appl. Phys. Lett., 15 juil. 1991, PP 304-306.

Ces courbes montrent bien que le résultat souhaité est obtenu pour un dispositif selon la présente invention bien que l'on ne dispose pas actuellement d'explication théorique pour la description de ce phénomène physique et qu'au contraire les explications majoritaires actuelles du phénomène de luminescence du silicium poreux écartent l'homme de métier de la recherche d'une luminescence dans du silicium poreux obtenu à partir de silicium amorphe.

L'homme de l'art notera que l'obtention de phénomènes de luminescence dans des couches minces de silicium ouvre la voie à de très nombreuses applications dans le cadre de la réalisation des circuits intégrés. En effet, les couches minces décrites sont compatibles avec les autres éléments connus de technologies en silicium amorphe déjà mises en oeuvre dans le cadre de la réalisation d'écrans électroluminescents.

Ainsi, la présente invention présente des applications dans les domaines de la microélectronique, de l'optique, des capteurs et de l'affichage. En outre, dans le domaine de la conversion d'énergie, la luminescence peut être excitée par diverses sources de rayonnement en particulier des rayonnements de grande énergie d'où il résulte une possibilité de réaliser un scintillateur à haut rendement.

## Revendications

1. Dispositif luminescent caractérisé en ce qu'il comprend, sur un substrat conducteur (1), une couche de silicium amorphe (2) déposée dont au moins une partie supérieure (3) a été rendue poreuse par anodisation.

2. Dispositif luminescent selon la revendication 1, caractérisée en ce que l'épaisseur de la couche de silicium amorphe est de l'ordre de 0,2 à 2 micromètres.

3. Dispositif luminescent selon la revendication 1, caractérisé en ce que l'épaisseur de la couche anodisée rendue poreuse est de l'ordre de 10 nm à 1 µm.

4. Dispositif luminescent selon la revendication 1, caractérisé en ce que le substrat est un métal.

5. Dispositif selon la revendication 1, caractérisé en ce que le substrat est une plaquette de silicium monocristallin dopée et métallisée sur sa face arrière.

6. Dispositif selon la revendication 1, caractérisé en ce que le substrat est un polymère conducteur.

7. Dispositif selon la revendication 1, caractérisé en ce que le substrat est une plaquette de verre revêtue d'une couche conductrice transparente du côté du dépôt de silicium amorphe.

8. Dispositif selon la revendication 1, caractérisé en ce que la couche de silicium poreux est oxydée.

9. Dispositif selon la revendication 1 ou 8, caractérisé en ce que la couche de silicium poreux oxydée est revêtue d'un diélectrique transparent de protection (4) tel que du nitrure de silicium.

10. Dispositif selon la revendication 1, caractérisé en ce que le dépôt de silicium amorphe est effectué à une température inférieure à 400°C.
